# EUROPEAN PATENT APPLICATION

(11) **EP 4 671 789 A1**
(43) Date of publication of application: **31.12.2025**
(21) Application number: 24904387.8
(22) Date of filing: 12.12.2024
(51) Int. Cl.: G01R 31/385, G01R 1/067, H01M 10/48, H01M 10/42, H01M 50/536

(54) **PICK-AND-PLACE DEVICE AND SECONDARY BATTERY MANUFACTURING DEVICE COMPRISING SAME**

(30) Priority: 14.12.2023 KR 20230181385
(71) Applicant: LG Energy Solution, Ltd., Seoul 07335 (KR)
(72) Inventor: SEO, Sang Yun, Daejeon 34122 (KR)
(74) Representative: Goddar, Heinz J.
(86) International application number: PCT/KR2024/096789
(87) International publication number: WO 2025/127822

(57) **Abstract**

The present invention relates to an electrode assembly inspection device, and more specifically, relates to an inspection device inspecting damage to an outermost shell separator of an electrode assembly, and a secondary battery manufacturing device applying the same to an in-line process and a manufacturing method thereof.

According to one example of the present invention, a secondary battery lead welding device may be provided, which comprises: a welder welding a plurality of electrode taps of an electrode assembly with electrode leads; an unloader receiving the electrode assembly, on which the welding is completed, from the welder and transferring it for a subsequent process; a pick-and-place device including a picker supporting the lower surface of the electrode assembly, on which the welding is completed, and transferring it to the unloader; and an upper end sensing device sensing whether the uppermost end separator of the electrode assembly is damaged through the picker.

## Description

### Technical Field

The present invention relates to an electrode assembly inspection device, and more specifically, relates to a pick-and-place device having a function of inspecting damage to the outermost shell separator of an electrode assembly, and a secondary battery manufacturing device applying the same on an in-line process and a manufacturing method thereof.

This application claims the benefit of priority based on Korean Patent Application No. 10-2023-0181385 dated December 14, 2023, and Korean Patent Application No. 10-2024-0184366 dated December 12, 2024, the disclosures of which are incorporated herein by reference in their entirety.

### Background art

Generally, as the supply of portable small electrical and electronic devices is spread, development of new type secondary batteries such as nickel-metal hydride batteries or lithium secondary batteries is actively underway. Recently, lithium secondary batteries have been widely used for automobiles as well as power tools.

The lithium secondary battery means a battery using carbon such as graphite as a negative electrode active material, a lithium containing oxide as a positive electrode material, and a non-aqueous solvent as an electrolyte.

Such a secondary battery is manufactured in the form of a battery assembly by accommodating an electrode assembly, in which a positive electrode, a separator, and a negative electrode are sequentially laminated, in an exterior material such as a pouch or a cylindrical can. Thereafter, a process of injecting the electrolyte into the battery assembly using an electrolyte injection device is performed.

Methods of laminating electrode assemblies are very various. Representatively, they can be classified into a jelly-roll (rollable) electrode assembly having a structure in which long sheet-shaped positive electrodes and negative electrodes are rolled up in a state where a separator is interposed therebetween, a stacked (laminated) electrode assembly in which a plurality of positive electrodes, a plurality of separators, and a plurality of negative electrodes, which are cut into units of a predetermined size, are sequentially laminated, and a stack/folding electrode assembly laminated by repeating a process of laminating unit positive electrodes or negative electrodes on a long sheet-shaped separator, and then folding the separator.

The stacked electrode assembly may also be formed by repeatedly laminating a unit positive electrode, a unit separator, and a unit negative electrode multiple times, and may also be formed by stacking them in the form of a unit cell, and then laminating a plurality of unit cells. In this instance, the unit cell means a form in which the unit separator, and the unit positive electrode or the unit negative electrode are laminated, which may also be called a semi-product.

As one example, the unit cell in which the unit separator, the unit positive electrode, the unit separator, and the unit negative electrode are laminated may be called a mono-cell, and the unit cell in which the unit separator, the unit positive electrode, and the unit separator are laminated may be called a half-cell. Of course, in the mono-cell, the laminating order of the positive electrode and the negative electrode may be changed, and in the half-cell, the negative electrode may be laminated instead of the positive electrode. The electrode assembly may be manufactured by manufacturing, first, a mono-cell and half-cells, and laminating multiple mono-cells, and then finally laminating the half-cells.

In the case of manufacturing such a unit cell and then laminating multiple unit cells, there is an advantage capable of providing sufficient adhesive force between the separator and the positive electrode, and between the separator and the negative electrode, and there is an advantage that lamination efficiency improvement and lamination reliability improvement are possible.

There may be various methods for manufacturing an electrode assembly by lamination, but the uppermost surface and the lowermost surface of the electrode assembly are formed through the separators. These separators can be called the uppermost end separator and the lowermost end separator, which can be collectively called outermost shell separators.

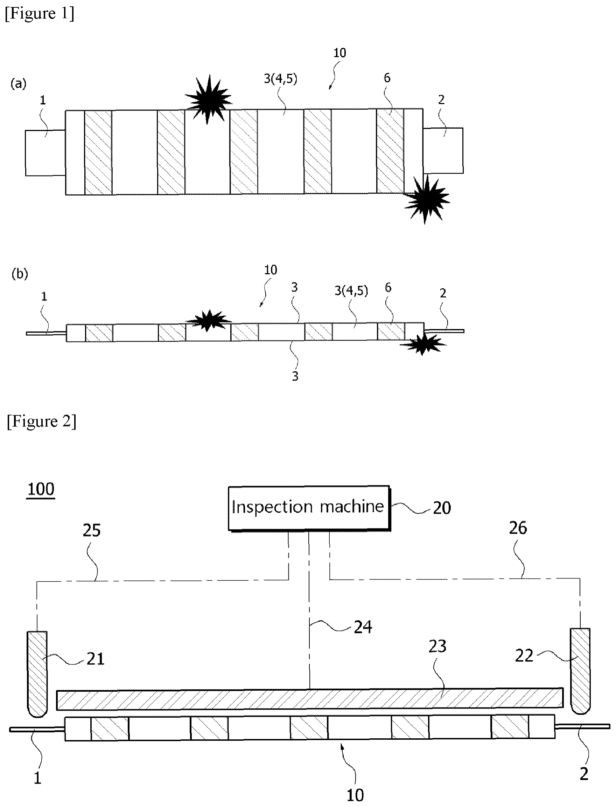

Figure 1(a) can be referred to as a plan view of an electrode assembly, and Figure 1(b) can be referred to as a front view of an electrode assembly.

As shown, the electrode assembly (10) is manufactured so that multiple positive electrodes (4), separators (3), and negative electrodes (5) are sequentially laminated, and the separators (3) are positioned on the uppermost surface and the lowermost surface. Then, a positive electrode lead (1) can be provided on one side of short sides in a rectangular electrode assembly (10), and a negative electrode lead (2) can be provided on the other side. Of course, it can also be manufactured so that both the positive electrode lead (1) and the negative electrode lead (2) are provided on one side of a short side.

An electrode assembly formed by sequentially laminating electrodes and separators can be referred to as a stacked electrode assembly, which can be distinguished from a jelly roll-type electrode assembly.

Electrode taps protruding from the positive electrode are provided, and these electrode taps are pre-welded to be electrically connected to each other. Thereafter, the pre-welded electrode taps are welded with the lead to form a positive electrode lead. In the same manner, the negative electrode lead is also formed.

The outer surface of the electrode assembly (10) is wrapped with a tape (6), whereby the laminated positive electrodes, negative electrodes, and separators can be fixed. Such an electrode assembly (10) is later inserted into a case such as a pouch together with an electrolyte, where manufacturing of the secondary battery can be completed through an activation process.

During the manufacturing process of the electrode assembly (10), the case where the outermost shell separator is damaged can occur. As one example, there may be a problem that the separator is torn or lifted, and furthermore, there may be a problem that the separator is folded. Conventionally, by resolving the damage to the outermost shell separator through sample visual inspection, there was a problem that reliability was lowered.

Damage to the outermost shell separator can occur at the long sides and corner portions of the electrode assembly (10), and can occur during various processes such as a transfer process or a taping process.

A prior art (KR 2022-0077252A) discloses a separator damage inspection device. According to the prior art, it discloses an inspection device sensing damage to a separator in a step before manufacturing an electrode assembly, as one example, in a mono-cell and half-cell step.

According to the prior art, an energization plate and a pressurization plate must be separately provided, so that it may be suitable for sample inspection, but there is a problem that it is difficult to apply to an electrode assembly manufacturing process which is performed automatically. In addition, it may be suitable for separator damage inspection in a mono-cell and a half-cell, but there is a problem that it is difficult to inspect damage to the outermost shell separator in an electrode assembly manufactured by laminating mono-cells and half-cells.

Particularly, according to the prior art, there is a problem that it is difficult to inspect damage to the outermost shell separator for the entire electrode assembly to be manufactured.

### Disclosure

### Technical Problem

Through one example of the present invention, it is intended to provide a device and a method capable of effectively sensing damage to a separator in an electrode assembly.

Through one example of the present invention, it is intended to provide a pick-and-place device capable of sensing damage to a separator in an electrode assembly.

Through one example of the present invention, it is intended to provide a shuttle device capable of sensing damage to a separator in an electrode assembly.

Through one example of the present invention, it is intended to provide a device and a method capable of effectively performing inspecting the uppermost end and lowermost end separators of an electrode assembly in a final process in which the electrode assembly is substantially manufactured.

Through one example of the present invention, it is intended to provide a lead welding device capable of performing inspecting damage to a separator of an electrode assembly on an in-line process.

Through one example of the present invention, it is intended to provide a method for manufacturing an electrode assembly capable of inspecting whether the uppermost end and lowermost end separators of an electrode assembly are damaged through an in-line process.

Through one example of the present invention, it is intended to provide a device and a method capable of effectively sensing damage to the uppermost end and lowermost end separators through a device and a process for transferring an electrode assembly to an unloader after lead welding and a device and a process for performing a transfer buffer of the electrode assembly in the unloader.

### Technical Solution

To achieve the above-described objects, according to one example of the present invention, it is possible to provide a pick-and-place device having a function of inspecting damage to a separator of an electrode assembly. Particularly, it is possible to provide a pick-and-place device comprising an upper end inspection device inspecting damage to the uppermost end separator of an electrode assembly.

The pick-and-place device may comprise a picker supporting a lower surface of an electrode assembly and moving the electrode assembly through three-axis movement.

A sensing device sensing whether the separator of the electrode assembly is damaged may be provided in the picker. Of course, the entire constitution or a partial constitution of the sensing device may be provided in the picker or the pick-and-place device. The sensing device may be operated in conjunction with the drive of the picker. Therefore, the pick-and-place device may be implemented by comprising the sensing device.

The sensing device may comprise an energization plate provided to move integrally with the picker, and moving up and down relative to the picker so as to be selectively in close contact with the upper surface of the electrode assembly; a probe provided to move integrally with the picker and moving up and down relative to the picker so as to be selectively in contact with electrode leads of the electrode assembly; a detector applying an electric current to the probe and sensing whether the separator of the electrode assembly is damaged depending on whether the electric current through the energization plate is sensed.

The sensing device may particularly sense whether the upper end separator of the electrode assembly is damaged. Therefore, it may be referred to as an upper end sensing device.

The pick-and-place device may be provided between a welder welding a plurality of electrode taps of the electrode assembly with the electrode leads and an unloader moving the electrode assembly, on which the welding is completed, for a subsequent process. The picker may move in three axes between the welder and the unloader to transfer the electrode assembly from one point to two points. Of course, the pick-and-place device may be a partial constitution of the welder or a partial constitution of the unloader.

The pick-and-place device may be provided so that the electrode assembly is separated and moved from a pallet on which the electrode assembly is seated and moved.

The welding device may be provided to sequentially weld a positive electrode lead and a negative electrode lead to the electrode assembly as the electrode assembly seated on the pallet moves through a linear motion system. A first electrode lead may be referred to as the positive electrode lead, and a second electrode lead may be referred to as the negative electrode lead, or vice versa.

For welding of the electrode leads, pre-welding of connecting a plurality of electrode taps to each other may be first performed, and the electrode leads may be welded to the plurality of pre-welded electrode taps. Therefore, the welder may be continuously provided with a first electrode pre-welding stage, a first electrode welding stage, a second electrode pre-welding stage, and a second electrode welding stage.

The electrode lead welding may be completed while one electrode assembly passes through a plurality of stages through the linear motion system.

The pick-and-place device may be provided so that the electrode assembly is separated and moved from the pallet located at a transfer position after all the welding is completed. That is, when all the welding is completed and the pallet is transferred to the transfer position, the electrode assembly at the transfer position is transferred. The transfer position may be referred to as a first point.

The picker may comprise a lower picker supporting the lower surface of the electrode assembly and an upper picker provided above the lower picker, and the energization plate may be provided to be movable up and down between the lower picker and the upper picker. It is also possible for the upper picker itself to move up and down.

The picker may comprise a cylinder provided to elevate the energization plate with respect to the upper picker. Of course, the picker may comprise a cylinder elevating the energization plate together with the upper picker with respect to the lower picker.

One end of the cylinder may be connected to the upper picker, and the other end may be connected to the energization plate. Therefore, when the cylinder is driven, the energization plate may move downward as the overall length of the cylinder increases.

The picker may comprise a connecting picker connecting the upper picker and the lower picker, and the connecting picker may also be provided with a cylinder elevating the energization plate.

To achieve the above-described objects, according to one example of the present invention, a shuttle device supporting a lower surface of an electrode assembly and transferring the electrode assembly through reciprocating motion may be provided, wherein the shuttle device comprises: a buffer plate provided so that the electrode assembly is supported and transferred; an energization plate provided on the upper surface of the buffer plate and provided to be in close contact with the lower surface of the seated electrode assembly; a probe moving up and down to be selectively in contact with electrode leads of the electrode assembly; and a detector applying an electric current to the probe and sensing whether the separator of the electrode assembly is damaged depending on whether the electric current through the energization plate is sensed.

A sensing device capable of sensing whether the lowermost end separator of the electrode assembly is damaged using the shuttle device may be implemented. The shuttle device may comprise a sensing device, and operation of the sensing device may be performed in conjunction with driving of the shuttle device.

The shuttle device may be provided in an unloader moving the electrode assembly, on which the welding is completed, from a welder welding a plurality of electrode taps of the electrode assembly with electrode leads, for a subsequent process.

It is preferable that the shuttle device or the sensing device comprises a cylinder provided to elevate the probe.

To achieve the above-described objects, according to one example of the present invention, a secondary battery lead welding device may be provided, which comprises: a welder welding a plurality of electrode taps of an electrode assembly with electrode leads; an unloader receiving the electrode assembly, on which the welding is completed, from the welder and transferring it for a subsequent process; a pick-and-place device including a picker supporting the lower surface of the electrode assembly, on which the welding is completed in the welder, and transferring it to the unloader; and an upper end sensing device sensing whether the uppermost end separator of the electrode assembly is damaged through the picker.

To achieve the above-mentioned purpose, according to one example of the present invention, a secondary battery lead welding device may be provided, which comprises: a welder sequentially moving an electrode assembly through a linear motion system and simultaneously welding a plurality of electrode taps of the electrode assembly with electrode leads; an unloader receiving the electrode assembly, on which welding is completed, from the welder and transferring it for a subsequent process; a pick-and-place device including a picker supporting the lower surface of the electrode assembly, on which the welding is completed in the welder, and transferring the electrode assembly to the unloader through three-axis movement; and an upper end sensing device sensing whether the uppermost end separator of the electrode assembly is damaged.

The upper end sensing device may be a partial constitution of the pick-and-place device.

The upper end sensing device may comprise an energization plate provided on the picker to be selectively in close contact with the upper surface of the electrode assembly, a probe being selectively in contact with the electrode leads of the electrode assembly, and a detector applying an electric current to the probe and sensing whether the uppermost end separator of the electrode assembly is damaged depending on whether the electric current through the energization plate is sensed.

The pick-and-place device may be provided between the welder and the unloader. Of course, the pick-and-place device may be a partial constitution of the welder or the unloader.

The pick-and-place device may be provided so that the electrode assembly is separated and moved from a pallet on which the electrode assembly is seated and moved.

It is preferable that the welder is provided to sequentially perform pre-welding of the first electrode tap, welding of the first electrode lead, pre-welding of the second electrode tap, and welding of the second electrode lead as the electrode assembly seated on the pallet moves through the linear motion system.

It is preferable that the pick-and-place device is provided so that the electrode assembly is separated and moved from the pallet located at a transfer position (first point) of the welder after the welding is completed.

The picker may comprise a lower picker supporting the lower surface of the electrode assembly and an upper picker provided above the lower picker, and the energization plate may be provided to be movable up and down between the lower picker and the upper picker.

The picker may comprise a cylinder provided to elevate the energization plate with respect to the upper picker.

It is preferable that one end of the cylinder is connected to the upper picker and the other end is connected to the energization plate.

The upper end sensing device may perform an inspection after moving the energization plate and the probe downward, before the picker moves to the first point and then contacts the lower surface of the electrode assembly, that is, in a state where the electrode assembly is still seated on the pallet. After the inspection is completed, the electrode assembly may be separated from the pallet while the entire picker rises.

The upper end sensing device may perform the inspection while the picker separates the electrode assembly from the pallet at the first point and transfers it to the second point. This is because the energization plate and the probe can be lowered relatively toward the electrode assembly relatively fixed to the picker, while the entire picker moves.

The unloader may comprise a shuttle device transferring the electrode assembly through reciprocating motion of a buffer plate supporting the lower surface of the electrode assembly.

A lower end inspection device sensing whether the lowermost end separator of the electrode assembly is damaged may be implemented through the shuttle device.

The lower end inspection device may comprise an energization plate provided on the upper surface of the buffer plate and provided to be in close contact with the lower surface of the seated electrode assembly; a probe being selectively in contact with the electrode leads of the electrode assembly; and a detector applying an electrical current to the probe and sensing whether the lowermost end separator of the electrode assembly is damaged depending on whether the electrical current through the energization plate is sensed.

To achieve the above-mentioned purpose, according to one example of the present invention, a secondary battery lead welding device may be provided, which comprises: a welder sequentially moving an electrode assembly through a linear motion system and simultaneously welding a plurality of electrode taps of the electrode assembly with electrode leads; an unloader receiving the electrode assembly, on which welding is completed, from the welder and transferring it for a subsequent process; a pick-and-place device including a picker supporting the lower surface of the electrode assembly, on which the welding is completed in the welder, and transferring the electrode assembly to the unloader through three-axis movement; and an upper end sensing device sensing whether the uppermost end separator of the electrode assembly is damaged.

According to the present example, the welding device welding the leads of the electrode assembly may comprise welders in which the leads of the electrode assembly are welded along a plurality of welding stages, and an unloader in which the electrode assembly, on which the welding is completed, is transferred from the welder.

Welding in the welder, transfer to the unloader, and transfer and buffering for input to the subsequent process from the unloader may also be performed automatically. That is, they may be performed in-line. In these processes, it may also be performed automatically inspectin g whether the uppermost end separator and the lowermost end separator of the electrode assembly are damaged. Particularly, by using the pick-and-place device and the shuttle device, independent and additional processes or inspection devices are not required, so that a very effective electrode assembly manufacturing process can be performed.

To achieve the above-described objects, according to one example of the present invention, it is possible to provide a control method of a welding device comprising welders welding leads to electrode taps of an electrode assembly and an unloader for moving the electrode assembly, on which the welding is completed, to a subsequent process.

The control method may comprise a welding process of welding leads to electrode taps while sequentially moving the electrode assembly on welding stages, a pick-up process of transferring the electrode assembly, on which the welding process is completed, to a shuttle device of the unloader using a pick-and-place device, and a shuttle process of transferring the electrode assembly using the shuttle device.

It is preferable that in the pick-up process, an upper end inspection process of inspecting whether the uppermost end separator of the electrode assembly is damaged using the pick-and-place device is performed. To perform the upper end inspection process, it is preferable that an energization plate in contact with the upper surface of the electrode assembly is provided in a picker of the pick-and-place device.

It is preferable that in the shuttle process, a lower end inspection process of inspecting whether the lowermost end separator of the electrode assembly is damaged using the shuttle device is performed. To perform the lower end inspection process, it is preferable that an energization plate in contact with the lower surface of the electrode assembly is provided in the shuttle device.

The welding process, the pick-up process, and the shuttle process are performed continuously to be in-line. That is, in an in-line process in which the welding process, pick-up process, and shuttle process are performed continuously and sequentially, the upper end inspection process and the lower end inspection process may be performed simultaneously.

### Advantageous Effects

Through one example of the present invention, it is possible to provide a device and a method capable of effectively sensing damage to a separator in an electrode assembly.

Through one example of the present invention, it is possible to provide a pick-and-place device capable of sensing damage to a separator in an electrode assembly. Particularly, it is possible to provide a pick-and-place device to which an inspection function for inspecting damage to the uppermost end separator of an electrode assembly is added.

Through one example of the present invention, it is possible to provide a shuttle device capable of sensing damage to a separator in an electrode assembly. Particularly, it is possible to provide a shuttle device to which an inspection function for inspecting damage to the lowermost end separator of an electrode assembly is added.

Through one example of the present invention, it is possible to provide a device and a method capable of effectively performing inspecting the uppermost end and lowermost end separators of an electrode assembly in a final process in which the electrode assembly is substantially manufactured.

Through one example of the present invention, it is possible to provide a lead welding device capable of performing inspecting damage to a separator of an electrode assembly on an in-line process.

Through one example of the present invention, it is possible to provide a method for manufacturing an electrode assembly capable of inspecting whether the uppermost end and lowermost end separators of an electrode assembly are damaged through an in-line process.

Through one example of the present invention, it is possible to provide a device and a method capable of effectively sensing damage to the uppermost end and lowermost end separators through a device and a process for transferring an electrode assembly to an unloader after lead welding and a device and a process for performing a transfer buffer of the electrode assembly in the unloader.

### Description of Drawings

Figure 1 is conceptual diagrams of an electrode assembly and a damaged portion of a separator of the electrode assembly,
Figure 2 is a conceptual diagram of an upper end inspection device for inspecting damage to an uppermost end separator according to one example of the present invention,
Figure 3 is a conceptual diagram of a lower end inspection device for inspecting damage to a lowermost end separator according to one example of the present invention,
Figure 4 is a layout of a lead welding device according to one example of the present invention,
Figures 5 and 6 are side views and front views of an upper end inspection device implemented in a pick-and-place device,
Figures 7 and 8 are side views and front views of a lower end inspection device implemented in a shuttle device, and
Figure 9 illustrates one example of a secondary battery manufacturing method according to one example of the present invention.

### Best Mode

Hereinafter, with reference to the attached drawings, an electrode assembly inspection device according to one example of the present invention will be described in detail.

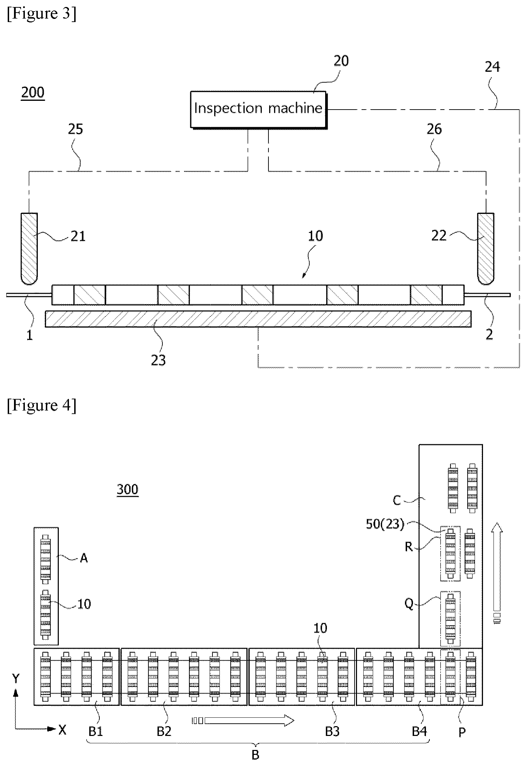

Figure 2 is a conceptual diagram of an inspection device for inspecting damage to an uppermost end separator of an electrode assembly, and Figure 3 is a conceptual diagram of an inspection device for inspecting damage to a lowermost end separator of an electrode assembly.

The inspection device according to the present example is preferably a device for inspecting an electrode assembly after electrode leads (including positive and negative electrode leads) are formed through welding.

As shown in Figure 2, the inspection device, particularly. the upper end inspection device (100) for determining whether the uppermost end separator is damaged may comprise an energization plate (23), a probe (21, 22), and an inspection machine (20).

The energization plate (23) is formed of a conductive plate which allows electricity to flow through it, which may be configured to cover the upper surface of the electrode assembly (10). That is, the energization plate (23) may be provided to uniformly press the upper surface of the electrode assembly (10) as a whole. Therefore, it is preferable that the energization plate (23) is manufactured to be larger than the upper surface area of the electrode assembly (10).

Preferably, the energization plate (23) may comprise a conductive sponge. As one example, the conductive sponge having a certain thickness and having an area covering the entire upper surface of the electrode assembly (10) may be provided. The electrode assembly (10) may be inserted to the inside of the conductive sponge to a certain depth. That is, as the electrode assembly is pressurized through the conductive plate, the entire uppermost end separator of the electrode assembly may be inserted to the inside of the conductive sponge. Through this, the entire outermost shell separator is uniformly in contact with the conductive sponge, so that a more reliable inspection may be performed.

The inspection machine (20) may be electrically connected to the energization plate (23) through a wire (24).

The inspection machine (20) may be electrically connected to the probe (21, 22) through the wire (25, 26). That is, the inspection machine (20) may be provided to apply an electrical current to the probe (21, 22).

The probes (21, 22) may be provided to contact the leads (1, 2). The leads are electrode leads, which may comprise a positive electrode lead (1) and a negative electrode lead (2).

Here, the energization plate (23) and the probes (21, 22) may be provided to move up and down for inspection of the outermost shell separator. As one example, after the electrode assembly (10), which is an inspection target, is transferred to an inspection position, the energization plate (23) and the probes (21, 22) may be lowered. Through the lowering, the energization plate (23) is in surface contact with the uppermost end separator, and the probes (21, 22) are in contact with the leads (1, 2).

Thereafter, in the inspection machine (20), an electrical current may be applied to the probes (21, 22), and it may be inspected whether the electrical current flows to the energization plate (23).

If the uppermost end separator is damaged, the electrode adjacent to the uppermost end separator may be exposed, and if the electrode is exposed, the electrical current may flow along the probes (21, 22), the leads (1, 2), and the energization plate (23). The inspection machine (20) senses such an electrical current, whereby it may inspect that the uppermost end separator has been damaged.

As described above, the electrode assembly may be manufactured through various lamination methods, so that the electrode in contact with the uppermost end separator may also be either the positive electrode or the negative electrode. As one example, in the case of the positive electrode, the negative electrode probe (22) and the negative electrode wire (26) may be omitted. As one example, in the case of the negative electrode, the positive electrode probe (21) and the positive electrode wire (25) may be omitted. However, in the case of a general-purpose inspection device, both the positive electrode probe (21) and the negative electrode probe (22) may also be provided.

Here, since the positions of the probes (21, 22) and the energization plate (23) should be different before and after the inspection, a moving device or a drive part changing the positions is required. As one example, the inspection device (100) may further comprise an elevating device moving the probes and the energization plate up and down.

According to the present example, the entire inspection device (100) may be applied to a part of the manufacturing process of the electrode assembly, that is, an in-line manufacturing device without being provided individually. That is, as the inspection function is imparted to some devices used in the in-line manufacturing device, it is possible to implement the inspection device (100) very easily. Such a manufacturing device may be a secondary battery tap welding device (tap welder) or a secondary battery lead welding device. The moving device or the drive part will be described below.

As shown in Figure 3, the inspection device, particularly, the lower end inspection device (200) for determining whether the lowermost end separator is damaged may comprise an energization plate (23), a probe (21, 22), and an inspection machine (20).

The present lower end inspection device (200) may be configured in the same manner as the above-described upper end inspection device (100). However, there may be a difference in that the energization plate (23) is provided to cover the lower surface of the electrode assembly (10). Therefore, redundant descriptions are omitted.

Here, the probes (21, 22) must have different positions before and after the inspection. That is, a moving device or a drive part changing the position of the probe is required. However, in the inspection device (200) according to the present example, the positions of the energization plate (23) before and after the inspection may be the same. Similarly, the entire inspection device (200) may be applied to a part of the manufacturing process of the electrode assembly, that is, the in-line manufacturing device without being provided individually. Such a manufacturing device may be a secondary battery tap welding device (tap welder) or a secondary battery lead welding device. The moving device or drive part will be described below.

Figure 4 illustrates one example of an electrode assembly manufacturing device. More specifically, Figure 4 illustrates arrangement of a lead welding device.

The lead welding device (300) may be a device gathering multiple electrode taps of an electrode assembly and welding them to one electrode lead. Multiple positive electrode taps are welded to the positive electrode lead and multiple negative electrode taps are welded to the negative electrode lead, so that the manufacturing of the electrode assembly may be completed. Thereafter, the electrode assembly may be transferred to a device for subsequent processes such as a packaging process for combining with a battery case such as a pouch, and an electrolyte injection process.

The electrode assembly may be manufactured by being laminated through an electrode assembly laminating device before the lead welding process. In a laminating device, multiple mono-cells may be laminated, and then a half-cell may be laminated last. In addition, in the laminating device, taping may be performed on the outer surface of the electrode assembly. After performing taping, the electrode assembly that has passed an appearance inspection may be subsequently input into the lead welding process. That is, a lamination & stacking process may be performed before the lead welding process.

The electrode assembly (10), on which the lamination is completed in the laminating device, may be moved to the lead welding device (300). To this end, the lead welding device (300) may comprise a loader (A). The laminating device may comprise the loader (A). Here, the loader may be referred to as a device inputting the electrode assembly into the welding device, which may be a partial constitution of the lead welding device (300).

The electrode assembly (10), on which the lamination is completed in the laminating device, may be moved to the welder (B) through the loader (A). In the welder (B), a welding process in which the positive electrode lead and the negative electrode lead are welded may be performed. The welder (B) may be referred to as a main constitution of the lead welding device (300). Here, the electrode assembly may be transferred from the loader (A) to the welder (B), particularly the positive electrode pre-welding stage (B1), using the pick-and-place device. That is, the electrode assembly may be moved from the stacking stage to the welding stage through the pick-and-place (PNP) device.

The welding process may be performed as a plurality of detailed processes, and the respective detailed processes may be performed in different stages.

The detailed processes may comprise positive electrode pre-welding, positive electrode main-welding, negative electrode pre-welding, and negative electrode main-welding. These detailed processes may be performed through detailed devices or individual stages.

Here, the pre-welding may comprise a tap guide process of collecting multiple electrode taps in the center while pressing them up and down. After the tap guide process is completed, the welding is performed through ultrasonic fusion so that the electrode taps are electrically connected and fixed. This may be called the pre-welding.

The main welding may be called a process of welding electrode leads to be electrically connected and fixed to the pre-welded electrode taps. Therefore, a single electrode lead may be electrically connected and fixed to multiple electrode taps.

In the positive electrode pre-welding stage (B1), the positive electrode taps of the electrode assembly may be pre-welded, and then the electrode assembly may be moved to the main welding stage (B2). The positive electrode lead may be welded in the main welding stage (B2).

Thereafter, in the negative electrode pre-welding stage (B3), the negative electrode taps of the electrode assembly may be pre-welded, and then the electrode assembly may be moved to the main welding stage (B4). The negative electrode lead may be welded in the main welding stage (B4).

That is, the negative electrode pre-welding and main welding may be performed after the positive electrode pre-welding and main welding are performed. Of course, the positive electrode pre-welding and main welding may be performed after the negative electrode pre-welding and main welding are performed.

In the multiple stages (B1 to B4), the electrode assembly (10) may be transferred through a linear motion system or a linear moving system (LMS). The linear motion system may comprise a plurality of pallets, and the electrode assembly (10) may be seated on the pallets. That is, the electrode assembly (10) sequentially moves through the stages in a state where it is positioned on the pallets, and through this, the first electrode lead and the second electrode lead are sequentially welded, so that the welding may be completed overall.

The electrode assembly, on which all the welding processes are completed, is transferred to an unloader (C) through the pick-and-place device.

The welder (B) is provided with a linear motion system, so that multiple pallets move linearly. That is, the electrode assembly seated on the pallets linearly moves through the linear motion system in sequence.

The linear motion system may be referred to as a system in which multiple pallets are disposed at a regular interval on a circular track, and multiple pallets simultaneously perform repeated movement and stopping at a regular interval.

The electrode assembly may be transferred from the welder (B) to the unloader (C) using the pick-and-place device. Particularly, it may be transferred to the unloader (C) from the negative electrode main welding stage (B4). The electrode assembly (10) is positioned at the transfer position (P, first point) of the welder (B) just before being transferred to the unloader (C). Here, the transfer position (P) may be referred to as a position where the electrode assembly is seated on the pallets just before being transferred to the unloader (C) after all the welding process of the electrode assembly are completed.

The unloader (C) may be provided with a shuttle (Q, R) device transferring the electrode assembly. The shuttle device may be referred to as a device for transferring the electrode assembly from a specific location to another specific location while reciprocating.

First, the shuttle (Q, R) device may comprise a first shuttle (Q) and a second shuttle (R). The first shuttle (Q) may be referred to as a constitution in which the electrode assembly transferred from the welder (B) is seated thereon, and the second shuttle (R) may be referred to as a constitution in which the electrode assembly transferred from the first shuttle (Q) is seated thereon. The second shuttle may be a constitution for transferring a plurality of electrode assemblies integrally after the plurality of electrode assemblies is seated.

Therefore, according to the present example, the loading process, the welding process, and the unloading process may be performed continuously as a whole. In addition, the laminating process may also be performed continuously. That is, the electrode assembly may be manufactured in-line through the pick-and-place device and the linear motion system. Here, according to the present example, the outermost shell separator of the electrode assembly may be inspected during this in-line process. That is, the inspection may be performed using a device performing the in-line process.

Since the pick-and-place device and the linear motion system are devices generally used in the secondary battery manufacturing process, the detailed descriptions thereof will be omitted.

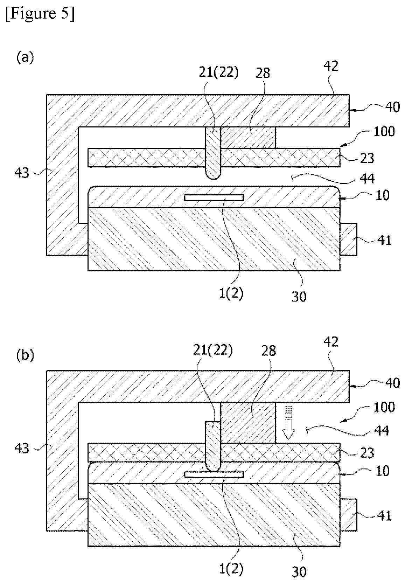

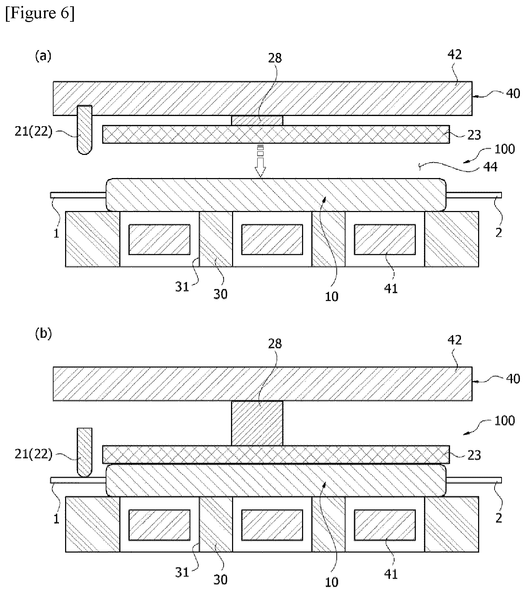

Hereinafter, with reference to Figures 5 and 6, an inspection device for inspecting the upper end separator of the electrode assembly will be described in detail.

Figure 5 is side views of an inspection device inspecting using a pick-and-place device, and Figure 6 is front views of an inspection device inspecting using a pick-and-place device.

A pick-and-place device moving the electrode assembly (10) is provided between the welder (B) and the unloader (C). Particularly, the pick-and-place device moves in three axes between the transfer location (P, first location) and the first shuttle (Q, second location). For convenience of explanation, the x-y direction is referred to as planar movement and the z direction is referred to as elevation movement.

The pick-and-place device may comprise a picker (40) in which the electrode assembly (10) is seated and then moved. The entire picker (40) performs plane movement and elevation movement to move the electrode assembly from the transfer location (P) to the first shuttle (Q).

The picker (40) may comprise a lower picker (41), in which the lower surface of the electrode assembly (10) is supported and transferred, such as a lifter of a forklift, and the lower picker (41) may be formed in a fork shape. The lower picker (41) supports the electrode assembly (10) seated on the pallet (30) while moving from the bottom to the top, and accordingly, the electrode assembly (10) is released from the pallet (30).

The pallet (30) has an opening (31) so as not to interfere with the rising lower picker (41). Multiple openings (31) may be provided. That is, while the lower picker (41) rises, the fork-shaped lower picker (41) passes through the opening (31) of the pallet, whereby the electrode assembly (10) may be released from the pallet (30) and seated on the lower picker (41).

Meanwhile, according to the present example, the picker (40) may comprise an upper picker (42). The upper picker (42) may be provided to have a predetermined space (44) with the lower picker (41) from the upper portion of the lower picker (41). The height of the predetermined space (44) between the upper picker (42) and the lower picker (41) may be fixed. To this end, a connecting picker (43) connecting one end of the lower picker (41) and the upper picker (42) may be provided. Therefore, the cross-sectional shape of the picker (40) may have a channel shape or a " 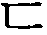 " shape.

As illustrated, a device for inspecting the uppermost end separator of the electrode assembly may be implemented through the picker (40).

Specifically, an upper end inspection device (100) may be provided using the space (44) between the upper picker (42) and the lower picker (41).

An energization plate (23) may be provided in the space (44), and the energization plate (23) may move up and down within the space (44). Probes (21, 22) may be provided to move up and down inside the space (44) or outside the space (44).

A cylinder (28) for elevating the energization plate (23) and probes (21, 22) may be provided. The cylinder (28) may be provided to elevate the energization plate (23) and probes (21, 22) integrally, or may be provided to elevate them separately.

One end of the cylinder (28) may be fixed to the upper picker (42) and the other end may be connected to the energization plate (23). When the length of the cylinder (28) increases by the driving of the cylinder, the energization plate (23) moves downward. Of course, in this instance, the probes (21, 22) also move downward.

Figures 5(a) and 6(a) illustrate a state where the energization plate (23) and the probes (21, 22) are in the position (original position) before moving downward, and Figures 5(b) and 6(b) illustrate a state where the energization plate (23) and the probes (21, 22) are in the position (inspection position) after moving downward.

At the inspection position, the energization plate (23) is in close contact with the upper surface of the electrode assembly (10), and the probes (21, 22) are in contact with the leads (1, 2) of the electrode assembly (10). In this instance, as an electrical current is applied to the probes (1, 2), it is possible to inspect whether the upper outermost shell separator is damaged.

Here, to move the electrode assembly (10), the picker (41) rises overall. That is, the electrode assembly (10) is separated from the pallet (30). Therefore, the inspection time through the inspection device (100) may vary.

As one example, as illustrated, the energization plate (23) moves downward in a state where the electrode assembly (10) is seated on the pallet (30), whereby the inspection may be performed. At this time, the inspection may be performed after the electrode assembly (10) is pressed in both up and down directions by the pallet (30) and the energization plate (23). When the inspection is completed, the electrode assembly (10) may be transferred after the entire picker (41) rises. In this case, it can be known that the transfer is performed after the inspection.

As one example, the inspection may be performed during the transfer of the electrode assembly (10) after the entire picker (41) rises and then the electrode assembly (10) is separated from the pallet (30). That is, the energization plate (23) moves downward during transfer of the electrode assembly (10), whereby the inspection may be performed. At this time, the inspection may be performed after the electrode assembly (10) is pressed in both up and down direction by the lower picker (41) and the energization plate (23). In this case, it can be known that the inspection is performed during transfer.

According to the present example, both the transfer after inspection and the inspection during transfer may be possible. In the case of the transfer after inspection, a separate time for inspection is required, whereby the process time may increase. This is because the inspection time and transport time are required. On the other hand, the inspection during transfer does not require a separate time for inspection.

For this reason, it is possible to very easily inspect damage to the uppermost end separator of the electrode assembly by using the manufacturing device and manufacturing method using the existing welder and PNP.

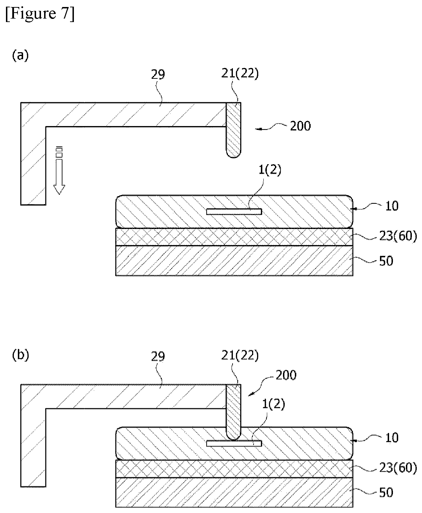

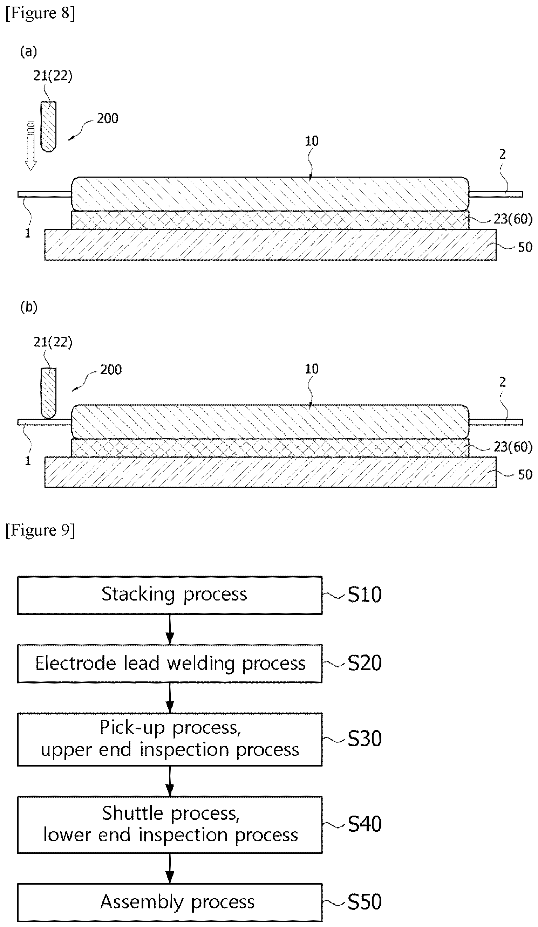

Hereinafter, the lower end inspection device (200) will be described in more detail with reference to Figures 7 and 8. Figure 7 is a side view of an inspection device (200) and Figure 8 is a front view of an inspection device (200).

Figure 7(a) and Figure 8(a) illustrate a state where probes (21, 22) are at a position (original position) before moving downward, and Figure 7(b) and Figure 8(b) illustrate a state where probes (21, 22) are at a position (inspection position) after moving downward.

The above-described shuttle device comprises a buffer plate (50) on which an electrode assembly is seated and transferred through reciprocating motion. A plurality of buffer plates (50) may be provided, and an electrode assembly (10) may be seated on each buffer plate (50). The buffer plate (50) may be moved to input the electrode assembly for a subsequent process, and the movement time and interval may be adjusted depending on to the speed of the subsequent process. In other words, when the electrode assembly (10) is seated on the buffer plate (50), the buffer plate (50) may be transferred after a minimum buffering time has elapsed.

According to the present example, an energization plate (23) may be provided on the upper surface of the buffer plate (50). Unlike the energization plate of the upper end inspection device (100) as described above, the energization plate (23) is a fixed constitution, so that it may be a partial constitution of the buffer plate (50). Therefore, it may be referred to as an energization seating portion (60) of the buffer plate.

The electrode assembly (10) may be seated on the energization plate (23) and transferred integrally with the energization plate (23).

According to the present example, it is possible to inspect whether the lowermost end separator is damaged during the buffering time. To this end, the probes (21, 22) descend to be in contact with the leads (1, 2), and the inspection machine applies an electrical current to the probes. If the applied electrical current flows through the energization plate and is sensed by the inspection machine, it may be determined that the lowermost end separator of the electrode assembly is damaged.

In the present example, only the probes (21, 22) may be provided to move up and down for inspection. The probes (21, 22) are provided near the buffer plate (50) independently of the buffer plate (50), and are positioned above the buffer plate (50) through a probe bracket (29).

As the entire probe bracket (29) moves up and down, the probes (21, 22) may also move up and down. The probes (21, 22) may move up and down through driving of a cylinder (not shown). Particularly, the cylinder moves the probe bracket (29) up and down, whereby the probes may may move up and down.

According to the lead welding device in accordance with the present example, it is possible to sense damage to the uppermost end separator and the lowermost end separator of the electrode assembly by using a device or process for transferring the electrode assembly from the welder to the unloader and a device or process for transferring the electrode assembly after buffering it in the unloader.

Therefore, it is possible to effectively sense damage to the separator of the electrode assembly in the in-line process without requiring a separate additional process or independent device. Particularly, by sensing damage to the separator in the process immediately before the process in which the electrode assembly is coupled with a battery case such as a pouch, it is possible to manufacture a secondary battery with higher reliability.

Meanwhile, according to one example of the present invention, it is possible to provide a control method of a welding device including a welder for welding leads to electrode taps of an electrode assembly and an unloader for moving the electrode assembly, on which the welding is completed, to a subsequent process.

As shown in Figure 9, a method for manufacturing a secondary battery, or a manufacturing process thereof may comprise an electrode lead welding process. Particularly, the electrode lead welding process (S20) may be essentially performed in a process for manufacturing a secondary battery having a stack-type electrode assembly.

The electrode lead welding process (S20) may be referred to as a process for welding positive electrode taps with positive electrode leads and welding negative electrode taps with negative electrode leads in a stack-type electrode assembly.

The welding process (S20) may be performed through a welding device. The welding device may comprise, in a narrow sense, a welder directly performing the welding, and may comprise an LMS moving the electrode assembly for welding. The welding device may comprise, in a broad sense, a loader moving an electrode assembly, on which the stacking process (S10) of the electrode assembly is completed, to the welder, and an unloader moving the electrode assembly, on which the welding process (S20) is completed, to a subsequent process, for example, an assembly process (S50).

The control method may comprise a welding process (S20) of welding leads to electrode taps while sequentially moving the electrode assembly in a welding stage, a pick-up process (S30) of transferring the electrode assembly, on which the welding process is completed, to a shuttle device of the unloader using a pick-and-place device, and a shuttle process (S40) of transferring the electrode assembly using the shuttle device.

According to the present example, it is preferable that the upper end inspection process is performed in the pick-up process (S30), and the lower end inspection process is performed in the shuttle process (S40).

That is, in the pick-up process (S30), the upper end inspection process of inspecting whether the uppermost end separator of the electrode assembly is damaged may be performed using the pick-and-place device. To perform the upper end inspection process, it is preferable that the energization plate in contact with the upper surface of the electrode assembly is provided in the picker of the pick-and-place device. Then, it is preferable that the pick-and-place device performing the pick-up process and the upper end inspection process is a partial constitution of the welding device.

In addition, in the shuttle process (S40), the lower end inspection process of inspecting whether the lowermost end separator of the electrode assembly is damaged may be performed using the shuttle device. To perform the lower end inspection process, it is preferable that the energization plate in contact with the lower surface of the electrode assembly is provided in the shuttle device. Then, it is preferable that the shuttle device performing the shuttle process and the lower end inspection process is a partial constitution of the welding device.

The welding process, pick-up process, and shuttle process are performed continuously in-line. That is, in the entire in-line process, the welding process, pick-up process, and shuttle process may be referred to as detailed processes. The in-line process may comprise an upper end inspection process and a lower end inspection process. Preferably, the upper end inspection process may be performed during the pick-up process, and the lower end inspection process may be performed during the shuttle process.

The welding process, pick-up process, and shuttle process form an in-line process which is performed continuously, and it is preferable that the upper end inspection process and the lower end inspection process are some processes of the in-line process. Therefore, it is preferable that the upper end inspection process and the lower end inspection process are performed for all electrode assemblies which are manufactured without performing only for some electrode assemblies. Of course, the relevant inspection process may not be performed for an electrode assembly that is confirmed to be defective, before the inspection process is performed.

Meanwhile, a stacking process (S10) is performed before the welding process (S20), and the electrode assembly manufactured by completing stacking may be transferred to the welding device through the loader. The electrode assembly, on which the welding is completed, may be transferred to a subsequent assembly process (S50) through the unloader. All processes from the stacking process (S10) to the assembly process (S50) may also be referred to as an in-line process which is performed continuously.

According to the present example, it is inspected whether the separator is damaged before moving from the welding process to the assembly process. The electrode assembly with a damaged separator may be determined to be defective during the activation process after the assembly process or after the completion of the activation process. This means that defective electrode assemblies are not initially selected and meaningless subsequent processes are performed. For this reason, according to the present example, defective products can be selected early, so that the manufacturing cost can be effectively reduced, and product quality can be improved, manufacturing time can be shortened, and compact equipment construction and operation can be achieved.

### Industrial Applicability

It is described in the Detailed Description of Invention.

## Claims

1. A pick-and-place device comprising a picker supporting a lower surface of an electrode assembly and moving the electrode assembly through three-axis movement, wherein the pick-and-place device comprises:
an energization plate provided to move integrally with the picker, and moving up and down relative to the picker to be selectively in close contact with the upper surface of the electrode assembly;
a probe provided to move integrally with the picker and moving up and down relative to the picker to be selectively in contact with electrode leads of the electrode assembly;
a detector applying an electric current to the probe and sensing whether the separator of the electrode assembly is damaged depending on whether the electric current through the energization plate is sensed.

2. The pick-and-place device according to claim 1, **characterized in that**
the pick-and-place device is provided between a welder welding a plurality of electrode taps of the electrode assembly with the electrode leads and an unloader moving the electrode assembly, on which the welding is completed, for a subsequent process.

3. The pick-and-place device according to claim 1, **characterized in that**
the pick-and-place device is provided so that the electrode assembly is separated and moved from a pallet on which the electrode assembly is seated and moved.

4. The pick-and-place device according to claim 3, **characterized in that**
the welding device is provided to sequentially weld a first electrode lead and a second electrode lead to the electrode assembly as the electrode assembly seated on the pallet moves through a linear motion system, and
the pick-and-place device is provided so that the electrode assembly is separated and moved from the pallet located at a transfer position after all the welding is completed.

5. The pick-and-place device according to claim 1, **characterized in that**
the picker comprises a lower picker supporting the lower surface of the electrode assembly and an upper picker provided above the lower picker, and
the energization plate is provided to be movable up and down between the lower picker and the upper picker.

6. The pick-and-place device according to claim 5, **characterized in that**
the picker comprises a cylinder provided to elevate the energization plate with respect to the upper picker.

7. The pick-and-place device according to claim 6, **characterized in that**
one end of the cylinder is connected to the upper picker, and the other end is connected to the energization plate.

8. A control method of a welding device comprising welders welding leads to electrode taps of an electrode assembly and an unloader for moving the electrode assembly, on which the welding is completed, to a subsequent process, wherein the control method of a welding device is **characterized by** comprising:
a welding process of welding leads to electrode taps while sequentially moving the electrode assembly on welding stages;
a pick-up process of transferring the electrode assembly, on which the welding process is completed, to a shuttle device of the unloader using a pick-and-place device; and
a shuttle process of transferring the electrode assembly using the shuttle device, wherein
in the pick-up process, an upper end inspection process of inspecting whether the uppermost end separator of the electrode assembly is damaged using the pick-and-place device is performed, and
in the shuttle process, a lower end inspection process of inspecting whether the lowermost end separator of the electrode assembly is damaged using the shuttle device is performed.

9. The control method of a welding device according to claim 8, **characterized in that**
the pick-and-place device comprises a picker provided with an energization plate in contact with the upper surface of the electrode assembly, to perform the upper end inspection process, and
the shuttle device comprises an energization plate supporting the lower surface of the electrode assembly.

10. The control method of a welding device according to claim 9, **characterized in that**
the welding process, pick-up process, and shuttle process form an in-line process which is performed continuously, and the upper end inspection process and the lower end inspection process are some processes of the in-line process, which are performed for all electrode assemblies.

11. A secondary battery lead welding device comprising:
a welder sequentially moving an electrode assembly through a linear motion system and simultaneously welding a plurality of electrode taps of the electrode assembly with electrode leads;
an unloader receiving the electrode assembly, on which welding is completed, from the welder and transferring it for a subsequent process;
a pick-and-place device including a picker supporting the lower surface of the electrode assembly, on which the welding is completed in the welder, and transferring the electrode assembly to the unloader through three-axis movement; and
an upper end sensing device having an energization plate provided on the picker to be selectively in close contact with the upper surface of the electrode assembly, a probe being selectively in contact with the electrode leads of the electrode assembly, and a detector applying an electric current to the probe and sensing whether the uppermost end separator of the electrode assembly is damaged depending on whether the electric current through the energization plate is sensed.

12. The secondary battery lead welding device according to claim 11, **characterized in that**
the pick-and-place device is provided between the welder and the unloader.

13. The secondary battery lead welding device according to claim 11, **characterized in that**
the pick-and-place device is provided so that the electrode assembly is separated and moved from a pallet on which the electrode assembly is seated and moved.

14. The secondary battery lead welding device according to claim 13, **characterized in that**
the welder is provided to sequentially perform pre-welding of the first electrode tap, welding of the first electrode lead, pre-welding of the second electrode tap, and welding of the second electrode lead as the electrode assembly seated on the pallet moves through the linear motion system.

15. The secondary battery lead welding device according to claim 14, **characterized in that**
the pick-and-place device is provided so that the electrode assembly is separated and moved from the pallet located at a transfer position of the welder after the welding is completed.

16. The secondary battery lead welding device according to claim 15, **characterized in that**
the picker comprises a lower picker supporting the lower surface of the electrode assembly and an upper picker provided above the lower picker, and
the energization plate is provided to be movable up and down between the lower picker and the upper picker.

17. The secondary battery lead welding device according to claim 16, **characterized in that**
the picker comprises a cylinder provided to elevate the energization plate with respect to the upper picker.

18. The secondary battery lead welding device according to claim 6, **characterized in that**
one end of the cylinder is connected to the upper picker and the other end is connected to the energization plate.

19. The secondary battery lead welding device according to claim 11, **characterized in that**
the unloader comprises a shuttle device transferring the electrode assembly through reciprocating motion of a buffer plate supporting the lower surface of the electrode assembly.

20. The secondary battery lead welding device according to claim 19, **characterized in that**
the shuttle device comprises a lower end inspection device, and
the lower end inspection device comprises:
an energization plate provided on the upper surface of the buffer plate and provided to be in close contact with the lower surface of the seated electrode assembly;
a probe being selectively in contact with the electrode leads of the electrode assembly; and
a detector applying an electrical current to the probe and sensing whether the lowermost end separator of the electrode assembly is damaged depending on whether the electrical current through the energization plate is sensed.
